# EUROPEAN PATENT APPLICATION

(11) **EP 4 654 226 A1**
(43) Date of publication of application: **26.11.2025**
(21) Application number: 24875766.8
(22) Date of filing: 10.10.2024
(51) Int. Cl.: H01B 12/00

(54) **MEMORY AND MANUFACTURING METHOD THEREFOR, AND ELECTRONIC DEVICE**

(30) Priority: 01.04.2024 CN 202410389602
(71) Applicant: CXMT Corporation, Hefei, Anhui 230601 (CN)
(72) Inventor: DENG, Fangxin, Hefei, Anhui 230601 (CN); DU, Guoan, Hefei, Anhui 230601 (CN); PIAO, Cheng, Hefei, Anhui 230601 (CN); ZHANG, Shiqing, Hefei, Anhui 230601 (CN)
(74) Representative: Gulde & Partner
(86) International application number: PCT/CN2024/123954
(87) International publication number: WO 2025/208828

(57) **Abstract**

A memory, a manufacturing method thereof, and an electronic device are provided. The memory includes a first semiconductor structure and a second semiconductor structure coupled to the first semiconductor structure. The first semiconductor structure includes a plurality of memory arrays arranged in an array and spaced apart from each other, each memory array includes a plurality of memory cells arranged in an array, each memory cell includes a vertical transistor extending in a first direction and a capacitor coupled to the vertical transistor, the capacitor includes a first electrode and a second electrode opposite to each other, and the first electrode is coupled to the vertical transistor; the second semiconductor structure includes a peripheral circuit and is disposed on a side of the vertical transistor away from the capacitor in the first direction; the first semiconductor structure further includes a common electrode electrically connected to the second electrodes of the capacitors in the plurality of memory arrays and a common electrode contact plug disposed on a same side of the common electrode as the vertical transistors in the first direction, and the common electrode is coupled to the peripheral circuit through the common electrode contact plug.

## Description

### TECHNICAL FIELD

The embodiments of the present disclosure relate to the field of semiconductor technologies, and in particular, to a memory, a manufacturing method thereof, and an electronic device.

### BACKGROUND

Dynamic random access memory (DRAM) is a type of semiconductor memory. Compared with static memory, the DRAM has the advantages of a simpler structure, a lower manufacturing cost, and a higher storage density. With the development of technology, the application of the DRAM is becoming increasingly widespread.

The current DRAM generally includes a plurality of memory banks, each memory bank includes a plurality of memory arrays, each memory array shares the same common electrode, and common electrodes corresponding to different memory arrays are separated from each other, such that other functional devices (generally including passive devices such as decoupling capacitors) are disposed between adjacent memory arrays. However, such a configuration also limits the scaling down of the size of memory chips.

### SUMMARY

According to a first aspect of the embodiments of the present disclosure, a memory is provided. The memory includes:
a first semiconductor structure, including a plurality of memory arrays arranged in an array and spaced apart from each other, where each memory array of the plurality of memory arrays includes a plurality of memory cells arranged in an array, and each memory cell of the plurality of memory cells includes a vertical transistor extending in a first direction and a capacitor coupled to the vertical transistor, the capacitor including a first electrode and a second electrode opposite to each other, and the first electrode being coupled to the vertical transistor; and
a second semiconductor structure, including a peripheral circuit and being bonded to the first semiconductor structure, where the second semiconductor structure is disposed on a side of the vertical transistor away from the capacitor in the first direction,
where the first semiconductor structure further includes a common electrode and a common electrode contact plug, the common electrode being electrically connected to the second electrodes of the capacitors in the plurality of memory arrays, and the common electrode contact plug and the vertical transistors being disposed on a same side of the common electrode in the first direction, the common electrode being coupled to the peripheral circuit through the common electrode contact plug.

In some embodiments, the common electrode includes a plurality of first plate-shaped portions in one-to-one correspondence with the plurality of memory arrays and a second plate-shaped portion connecting the plurality of first plate-shaped portions, the second plate-shaped portion being disposed between adjacent memory arrays and closer to the second semiconductor structure than the plurality of first plate-shaped portions.

In some embodiments, an orthographic projection of the common electrode contact plug along the first direction is located within an orthographic projection of the second plate-shaped portion along the first direction.

In some embodiments, the plurality of first plate-shaped portions and the second plate-shaped portion are integrally formed.

In some embodiments, an orthographic projection of the common electrode contact plug along the first direction is located within a region defined by four adjacent vertex corners of orthographic projections of four adjacent memory arrays along the first direction.

In some embodiments, the capacitor further includes a capacitor dielectric layer disposed between the first electrode and the second electrode, the capacitor dielectric layer being integrally formed in the plurality of memory arrays, and the common electrode contact plug penetrating the capacitor dielectric layer and being coupled to the common electrode.

In some embodiments, the capacitor further includes a capacitor dielectric layer disposed between the first electrode and the second electrode, the capacitor dielectric layer being integrally formed in each of the plurality of memory arrays, and the capacitor dielectric layers of different memory arrays of the plurality of memory arrays being separated from each other.

In some embodiments, the second electrode is integrally formed in each of the plurality of memory arrays, and the second electrodes of different memory arrays of the plurality of memory arrays are integrally formed or separated from each other.

In some embodiments, the second electrode in the plurality of memory arrays and the common electrode are integrally formed.

In some embodiments, each of the plurality of memory arrays further includes a plurality of word lines extending in a second direction and a plurality of bit lines extending in a third direction, where in each of the plurality of memory arrays, each word line of the plurality of word lines is coupled to a row of vertical transistors arranged in the second direction, and each bit line of the plurality of bit lines is coupled to a column of vertical transistors arranged in the third direction; and the second direction is perpendicular to the first direction, the third direction is perpendicular to the first direction, and the third direction intersects with the second direction.

In some embodiments, the word lines in adjacent memory arrays are spaced apart from each other, and the bit lines in adjacent memory arrays are spaced apart from each other.

In some embodiments, the first semiconductor structure further includes: a plurality of first contact plugs in one-to-one correspondence with and coupled to the plurality of word lines in each of the plurality of memory arrays, each first contact plug of the plurality of first contact plugs being disposed on a side of a corresponding word line close to the second semiconductor structure; and a plurality of second contact plugs in one-to-one correspondence with and coupled to the plurality of bit lines in each of the plurality of memory arrays, each second contact plug of the plurality of second contact plugs being disposed on a side of a corresponding bit line close to the second semiconductor structure.

In some embodiments, the first semiconductor structure further includes a first interconnection layer, the first interconnection layer being disposed on a side of the plurality of memory arrays close to the second semiconductor structure in the first direction; the second semiconductor structure further includes a second interconnection layer, the second interconnection layer being disposed on a side of the peripheral circuit close to the first semiconductor structure in the first direction; and the memory further includes a bonding interface disposed between the first interconnection layer and the second interconnection layer.

In some embodiments, the second semiconductor structure further includes a third interconnection layer, the third interconnection layer being disposed on a side of the peripheral circuit away from the first semiconductor structure, and the third interconnection layer being configured to couple the peripheral circuit with an external circuit.

According to a second aspect of the embodiments of the present disclosure, a method for manufacturing a semiconductor structure is provided. The method includes:
providing a first semiconductor structure, where the first semiconductor structure includes a plurality of memory arrays arranged in an array and spaced apart from each other, each memory array of the plurality of memory arrays includes a plurality of memory cells arranged in an array, and each memory cell of the plurality of memory cells includes a vertical transistor extending in a first direction and a capacitor coupled to the vertical transistor, the capacitor including a first electrode and a second electrode opposite to each other, and the first electrode being coupled to the vertical transistor; and where the first semiconductor structure further includes a common electrode and a common electrode contact plug, the common electrode being electrically connected to the second electrodes of the capacitors in the plurality of memory arrays, and the common electrode contact plug and the vertical transistors being disposed on a same side of the common electrode in the first direction;
providing a second semiconductor structure, where the second semiconductor structure includes a peripheral circuit; and
bonding the first semiconductor structure to the second semiconductor structure, so that the common electrode is coupled to the peripheral circuit through the common electrode contact plug, where the second semiconductor structure is disposed on a side of the vertical transistor away from the capacitor in the first direction.

According to a third aspect of the embodiments of the present disclosure, an electronic device is provided. The electronic device includes:
a processor; and
the memory according to any one of the embodiments of the present disclosure, the memory being coupled to the processor.

In the embodiments of the present disclosure, a plurality of memory arrays share the same common electrode, and accordingly, other functional devices (such as decoupling capacitors) may be disposed at the periphery of the plurality of memory arrays, such that the space between adjacent memory arrays can be reduced, which can decrease the size of the first semiconductor structure as a whole, thereby facilitating the scaling down of the chip size of the memory.

### BRIEF DESCRIPTION OF THE DRAWINGS

FIG. 1 is a schematic diagram of a cross-sectional structure of a memory according to some embodiments of the present disclosure;
FIG. 2 is a schematic layout diagram of a plurality of memory arrays in a memory according to some embodiments of the present disclosure;
FIG. 3a is a schematic diagram of a cross-sectional structure of a memory taken along line A1A2 in FIG. 2 according to some embodiments of the present disclosure;
FIG. 3b is a schematic diagram of a cross-sectional structure of a memory taken along line B1B2 in FIG. 2 according to some embodiments of the present disclosure;
FIG. 4 is a schematic diagram of a planar structure of an interconnection line according to some embodiments of the present disclosure;
FIG. 5a is a schematic diagram of a partial cross-sectional structure of a memory taken along line A1A2 in FIG. 2 according to some other embodiments of the present disclosure;
FIG. 5b is a schematic diagram of a partial cross-sectional structure of a memory taken along line B1B2 in FIG. 2 according to some other embodiments of the present disclosure;
FIG. 6a is a schematic diagram of a partial cross-sectional structure of a memory taken along line A1A2 in FIG. 2 according to yet some other embodiments of the present disclosure;
FIG. 6b is a schematic diagram of a partial cross-sectional structure of a memory taken along line B1B2 in FIG. 2 according to yet some other embodiments of the present disclosure;
FIG. 7 is a flow chart of a method for manufacturing a memory according to some embodiments of the present disclosure; and
FIG. 8 is a schematic block diagram of a structure of an electronic device according to some embodiments of the present disclosure.

### DETAILED DESCRIPTION

The technical solutions of the present disclosure will be further elaborated below with reference to the drawings and embodiments. While exemplary implementations of the present disclosure are shown in the drawings, it should be understood that the present disclosure may be implemented in various forms and should not be limited by the embodiments set forth herein. Rather, these embodiments are provided so that the present disclosure will be more thoroughly understood and the scope of the present disclosure will be fully conveyed to those skilled in the art.

The present disclosure is more specifically described in the following paragraphs with reference to the drawings by way of example. The advantages and features of the present disclosure will become apparent from the following description and claims. It should be noted that the drawings are all in a very simplified form and not to a precise scale, and are provided only for the purpose of facilitating a convenient and clear description of the embodiments of the present disclosure.

It will be understood that the meaning of "on", "above", and "over" in the present disclosure should be interpreted in the broadest manner such that "on" not only includes the meaning of "on" something with no intermediate feature or layer therebetween (i.e., directly on something) but also includes the meaning of "on" something with an intermediate feature or a layer therebetween.

In the embodiments of the present disclosure, the terms "first", "second", "third", and the like are used for distinguishing similar objects and are not necessarily used for describing a particular order or sequence.

In the embodiments of the present disclosure, the term "layer" refers to a material portion that includes a region having a thickness. A layer may extend over the entirety of the underlying or overlying structure or may have an extent that is less than the extent of the underlying or overlying structure. Furthermore, a layer may be a region of a homogeneous or inhomogeneous continuous structure having a thickness less than the thickness of a continuous structure. For example, a layer may be located between the top surface and the bottom surface of a continuous structure, or a layer may be located between any pair of horizontal planes at the top surface and the bottom surface of the continuous structure. A layer may extend horizontally, vertically, and/or along inclined surfaces. A layer may include a plurality of sub-layers.

In the embodiments of the present disclosure, the term "couple" means that two (or more) conductive structures are operatively connected to each other, and may include, but are not limited to, the following cases according to actual needs: 1) the two conductive structures are directly electrically connected; 2) the two conductive structures are indirectly electrically connected (through other conductive structures); 3) one of the two conductive structures may control an electrical property of the other of the two conductive structures in response to an electrical signal although no electrical connection is made between the two conductive structures (e.g., an insulating layer is provided therebetween), e.g., a gate (or word line) is coupled to an active region (or channel region).

It should be noted that unless conflicting, the technical solutions and the technical features described in the embodiments of the present disclosure may be arbitrarily combined.

In at least some embodiments of the present disclosure, a memory is provided. The memory includes a first semiconductor structure and a second semiconductor structure coupled to the first semiconductor structure. The first semiconductor structure includes a plurality of memory arrays arranged in an array and spaced apart from each other, each memory array of the plurality of memory arrays includes a plurality of memory cells arranged in an array, each memory cell of the plurality of memory cells includes a vertical transistor extending in a first direction and a capacitor coupled to the vertical transistor, the capacitor includes a first electrode and a second electrode opposite to each other, and the first electrode is coupled to the vertical transistor. The second semiconductor structure includes a peripheral circuit, and the second semiconductor structure is disposed on a side of the vertical transistor away from the capacitor in the first direction. The first semiconductor structure further includes a common electrode and a common electrode contact plug, where the common electrode is electrically connected to the second electrodes of the capacitors in the plurality of memory arrays, and the common electrode contact plug and the vertical transistors are disposed on the same side of the common electrode in the first direction; the common electrode is coupled to the peripheral circuit through the common electrode contact plug. In the embodiments of the present disclosure, a plurality of memory arrays share the same common electrode, and accordingly, other functional devices (such as decoupling capacitors) may be disposed at the periphery of the plurality of memory arrays, such that the space between adjacent memory arrays can be reduced, which can decrease the size of the first semiconductor structure as a whole, thereby facilitating the scaling down of the chip size of the memory.

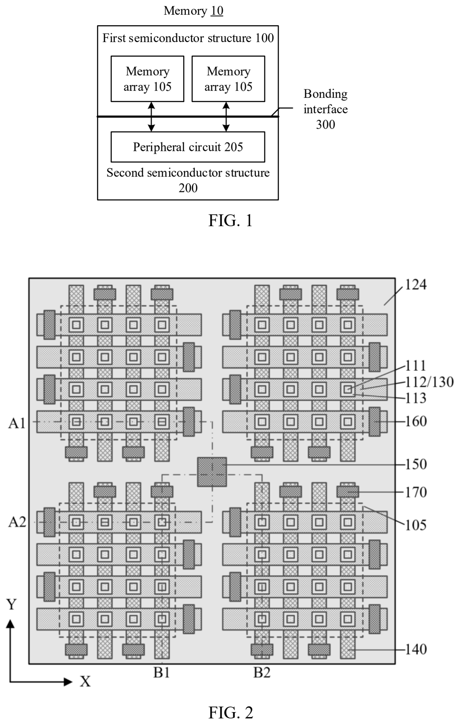

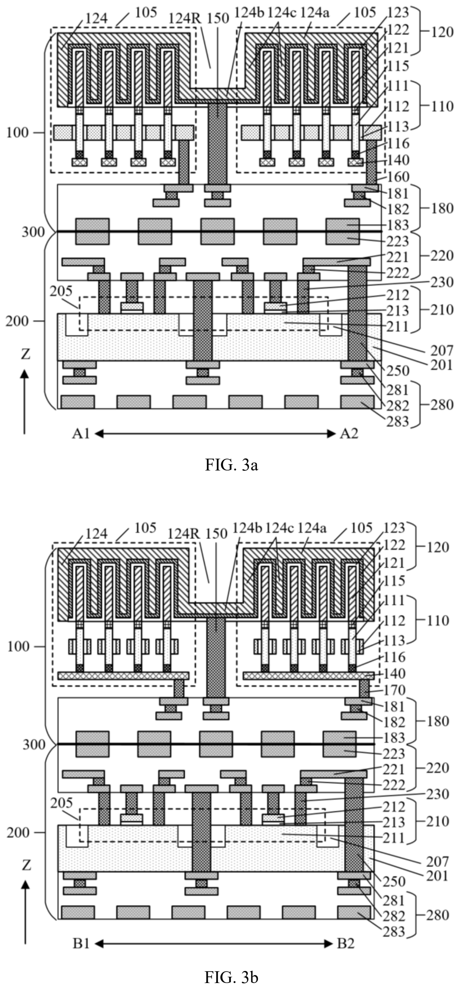

FIG. 1 is a schematic diagram of a cross-sectional structure of a memory according to some embodiments of the present disclosure; FIG. 2 is a schematic layout diagram of a plurality of memory arrays in a memory according to some embodiments of the present disclosure; FIG. 3a is a schematic diagram of a cross-sectional structure of a memory taken along line A1A2 in FIG. 2 according to some embodiments of the present disclosure; and FIG. 3b is a schematic diagram of a cross-sectional structure of a memory taken along line B1B2 in FIG. 2 according to some embodiments of the present disclosure.

For example, as shown in FIGS. 1, 2, 3a, and 3b, the memory 10 may include a first semiconductor structure 100 and a second semiconductor structure 200. The first semiconductor structure 100 may include a plurality of memory arrays 105 arranged in an array and spaced apart from each other, the second semiconductor structure 200 may include a peripheral circuit 205, and the first semiconductor structure 100 and the second semiconductor structure 200 may be bonded to each other through a bonding interface 300, such that the plurality of memory arrays 105 are respectively coupled to the peripheral circuit 205.

For example, as shown in FIGS. 2, 3a, and 3b, each memory array 105 may include a plurality of memory cells arranged in an array, and each memory cell includes a vertical transistor 110 extending in a first direction Z and a capacitor 120 coupled to the vertical transistor 110. The second semiconductor structure 200 may be disposed on a side of the vertical transistor 110 away from the capacitor 120 in the first direction Z.

It should be noted that the number of memory arrays in the drawings is exemplary and is not limited by the embodiments of the present disclosure. For example, in some examples, the memory 10 may include m × n memory arrays 105, where m represents the number of memory arrays 105 in a row direction (e.g., a second direction X mentioned below), and n represents the number of memory arrays 105 in a column direction (e.g., a third direction Y mentioned below). For example, both m and n are positive integers greater than or equal to 2. FIG. 2 illustrates a case where both m and n are 2.

For example, in some examples, as shown in FIGS. 2, 3a, and 3b, the vertical transistor 110 includes an active pillar 111 extending in the first direction Z, a gate 112 covering sidewalls of the active pillar 111, and a gate dielectric layer 113 between the active pillar 111 and the gate 112. For example, a material of the active pillar 111 may include any suitable semiconductor material, such as silicon, germanium, gallium arsenide, and oxide semiconductor materials. For example, the oxide semiconductor material may include, but is not limited to, indium gallium zinc oxide (IGZO), indium gallium oxide (IGO), indium zinc oxide (IZO), and the like. For example, a material of the gate 112 may include any suitable conductive material, such as titanium nitride (TiN), tantalum nitride (TaN), tungsten, metal silicide, doped polysilicon, or any combination thereof. For example, a material of the gate dielectric layer 113 may include any suitable dielectric material, such as silicon oxide, silicon nitride, a high-K dielectric material, or any combination thereof. For example, the high-K dielectric material may include, but is not limited to, hafnium oxide (HfO₂), zirconium oxide (ZrO₂), and the like. It should be noted that the vertical transistor 110 in the drawings is exemplary, and the structure of the vertical transistor 110 is not limited by the embodiments of the present disclosure. For example, the vertical transistor 110 may be a gate-all-around (GAA) transistor (as shown in the drawings), or may be a single-side gate transistor, a double-side (e.g., opposite-side) gate transistor, a triple-side gate transistor, or the like.

For example, as shown in FIGS. 3a and 3b, the capacitor 120 includes a first electrode 121 and a second electrode 122 opposite to each other as well as a capacitor dielectric layer 123 disposed between the first electrode 121 and the second electrode 122. For example, materials of both the first electrode 121 and the second electrode 122 include any suitable conductive material, such as titanium nitride (TiN), tantalum nitride (TaN), tungsten, metal silicide, doped polysilicon, or any combination thereof. For example, a material of the capacitor dielectric layer 123 includes any suitable dielectric material, such as silicon oxide, silicon nitride, a high-K dielectric material, or any combination thereof. For example, the material of the capacitor dielectric layer 123 may further include a dielectric material having ferroelectricity or antiferroelectricity, such as a hafnium oxide in a ferroelectric phase or a hafnium zirconium oxide in a ferroelectric phase. In other words, the capacitor 120 may be a ferroelectric capacitor.

For example, in some examples, as shown in FIGS. 3a and 3b, the first electrode 121 may be coupled to the vertical transistor 110 through a contact pad 115. For example, the first electrode 121 is coupled to a first source/drain of the vertical transistor 110. For example, a material of the contact pad 115 may include any suitable conductive material, such as titanium nitride (TiN), tantalum nitride (TaN), tungsten, metal silicide, doped polysilicon, or any combination thereof. For example, the shape and the structure of the contact pad 115 may be configured as desired to match the arrangement manner (e.g., square or hexagonal close-packed arrangements) of the plurality of capacitors 120 in the memory array 105. It should be noted that in some other examples, the contact pad 115 may be omitted, that is, the first electrode 121 may be directly coupled to the vertical transistor 110.

For example, as shown in FIGS. 2, 3a, and 3b, the first semiconductor structure 100 further includes a common electrode 124 and a common electrode contact plug 150. The common electrode 100 is electrically connected to the second electrodes 122 of the capacitors 120 in the plurality of memory arrays 105, that is, the plurality of memory arrays 105 share the same common electrode 100. The common electrode contact plug 150 and the vertical transistors 110 are disposed on the same side of the common electrode 124 in the first direction Z. The common electrode 124 is coupled to the peripheral circuit 205 (e.g., a ground terminal of the peripheral circuit 205) through the common electrode contact plug 150.

It should be noted that in the memory of the related art, each memory array shares the same common electrode, and common electrodes corresponding to different memory arrays are separated from each other, such that other functional devices (generally including passive devices such as decoupling capacitors) are disposed between adjacent memory arrays. However, such a configuration limits the scaling down of the size of memory chips. In the embodiments of the present disclosure, a plurality of memory arrays 105 share the same common electrode 100, and other functional devices (such as decoupling capacitors) may be disposed at the periphery of the plurality of memory arrays 105, such that the space between adjacent memory arrays 105 can be reduced, which can decrease the size of the first semiconductor structure 100 as a whole, thereby facilitating the scaling down of the chip size of the memory 10.

For example, a material of the common electrode 124 may include any suitable conductive material, such as titanium nitride (TiN), tantalum nitride (TaN), tungsten, doped polysilicon, silicon germanium (SiGe), or any combination thereof. For example, a material of the common electrode contact plug 150 may include any suitable conductive material, such as titanium nitride (TiN), tantalum nitride (TaN), tungsten, cobalt, metal silicide, or any combination thereof.

For example, in some examples, as shown in FIGS. 3a and 3b, the second electrode 122 is integrally formed in each memory array 105, and the capacitor dielectric layer 123 is integrally formed in each memory array 105. Further, the second electrode 122 is integrally formed in the plurality of memory arrays 105, and the capacitor dielectric layer 123 is integrally formed in the plurality of memory arrays 105, such that the manufacturing process of the first semiconductor structure 100 can be simplified. In other words, the second electrode 122 and the capacitor dielectric layer 123 may be shared by the plurality of memory arrays 105. In this case, as shown in FIGS. 3a and 3b, one end of the common electrode contact plug 150 penetrates the shared capacitor dielectric layer 123 to make a contact connection with the shared second electrode 122, thereby achieving the electrical connection between the common electrode contact plug 150 and the common electrode 124. It will be understood that on the basis of the embodiments shown in FIGS. 3a and 3b, one end of the common electrode contact plug 150 may further penetrate the shared second electrode 122 to make a direct contact connection with the common electrode 124. It will also be understood that in some examples, the second electrodes 122 of different memory arrays of the plurality of memory arrays 105 may be separated from each other, such that one end of the common electrode contact plug 150 may penetrate the shared capacitor dielectric layer 123 and then make a direct contact connection with the common electrode 124.

For example, in some examples, as shown in FIGS. 3a and 3b, the common electrode 124 may include a plurality of first plate-shaped portions 124a in one-to-one correspondence with the plurality of memory arrays 105, and a second plate-shaped portion 124b connecting the plurality of first plate-shaped portions 124a. The second plate-shaped portion 124b is disposed between adjacent memory arrays 105, and the second plate-shaped portion 124b is closer to the second semiconductor structure 200 than the plurality of first plate-shaped portions 124. For example, an orthographic projection of the second plate-shaped portion 124b in the first direction Z may be grid-like. It should be noted that in the present disclosure, the orthographic projection in a certain direction refers to an orthographic projection in a virtual plane perpendicular to the certain direction.

For example, in some examples, as shown in FIGS. 3a and 3b, the common electrode 124 may further include extension portions 124c extending in the first direction Z, each extension portion 124c is disposed on a sidewall of the first electrode 121 and connected to a corresponding first plate-shaped portion 124a, and the first plate-shaped portion 124a is connected to the second plate-shaped portion 124b through the extension portion 124c.

For example, in some examples, as shown in FIGS. 3a and 3b, a recess 124R is formed in the common electrode 124, the first plate-shaped portions 124a are located at both sides of an opening of the recess 124R, the second plate-shaped portion 124b is located at a bottom of the recess 124R, and some of the extension portions 124c are located at sidewalls of the recess 124R. For example, in some examples, the first semiconductor structure may further include a planarization layer (not shown in the figures) that is disposed on a side of the common electrode 124 away from the second semiconductor structure 200 and fills the recess 124R.

For example, in some examples, as shown in FIGS. 3a and 3b, the plurality of first plate-shaped portions 124a, the second plate-shaped portion 124b, and the extension portions 124c may be integrally formed. For example, in some examples, as shown in FIGS. 2, 3a, and 3b, the shape of an orthographic projection of the common electrode in the first direction Z may be a closed figure (e.g., without voids and/or seams therein).

For example, in some examples, as shown in FIGS. 3a and 3b, an orthographic projection of the common electrode contact plug 150 in the first direction Z may be located within the orthographic projection of the second plate-shaped portion 124b in the first direction. That is, the common electrode contact plug 150 is coupled to the second plate-shaped portion 124b to achieve coupling with the common electrode 124, thereby facilitating the shortening of the transmission path of the common electrode contact plug 150 and the decrease of the transmission resistance of the common electrode contact plug 150. For example, in some examples, the first semiconductor structure 100 may include a plurality of common electrode contact plugs 150, and the orthographic projection of at least one common electrode contact plug 150 in the first direction Z is located within the orthographic projection of the second plate-shaped portion 124b in the first direction.

For example, as shown in FIGS. 2, 3a, and 3b, each memory array 105 may further include a plurality of word lines 130 extending in a second direction X and a plurality of bit lines 140 extending in a third direction Y. In each memory array 105, each word line 130 is coupled to a row of vertical transistors 110 arranged in the second direction X. For example, the word line 130 is coupled to the gate of the vertical transistor 110, or the gate of the vertical transistor 110 is a part of the word line 130. Each bit line 140 is coupled to a column of vertical transistors 110 arranged in the third direction Y. For example, the bit line 140 is coupled to the second source/drain of the vertical transistor. For example, the second direction X is perpendicular to the first direction Z, and the third direction Y is perpendicular to the first direction Z. For example, the third direction Y intersects with the second direction X. For example, the third direction Y may be perpendicular to the second direction X. It should be noted that in the present disclosure, the definitions of a row and a column are relative and may be interchanged.

For example, a material of the word line 130 may include any suitable conductive material, such as titanium nitride (TiN), tantalum nitride (TaN), tungsten, metal silicide, doped polysilicon, or any combination thereof. For example, a material of the bit line 140 may include any suitable conductive material, such as titanium nitride (TiN), tantalum nitride (TaN), tungsten, metal silicide, doped polysilicon, or any combination thereof.

For example, as shown in FIGS. 2, 3a, and 3b, in each memory array 105, the plurality of word lines 130 may be spaced apart in the third direction Y, and the plurality of bit lines 140 may be spaced apart in the second direction X. Word lines 130 in adjacent memory arrays 105 may be spaced apart from each other and bit lines 140 in adjacent memory arrays 105 may be spaced apart from each other. In other words, two word lines 130 located on the same line (e.g., a line extending in the second direction X) in adjacent memory arrays 105 may each be independently controlled, and two bit lines 140 located on the same line (e.g., a line extending in the third direction Y) in adjacent memory arrays 105 may each be independently controlled.

For example, in some examples, as shown in FIGS. 3a and 3b, the bit line 140 may be coupled to the vertical transistor through a bit line contact plug 116. For example, a material of the bit line contact plug 116 may include any suitable conductive material, such as titanium nitride (TiN), tantalum nitride (TaN), tungsten, metal silicide, doped polysilicon, or any combination thereof.

For example, as shown in FIGS. 2, 3a, and 3b, the first semiconductor structure may further include a plurality of first contact plugs 160 in one-to-one correspondence with and coupled to the plurality of word lines 130 in each memory array 105, and a plurality of second contact plugs 170 in one-to-one correspondence with and coupled to the plurality of bit lines 140 in each memory array 105. Each first contact plug 160 is disposed on a side of a corresponding word line 130 close to the second semiconductor structure 200, and each second contact plug 170 is disposed on a side of a corresponding bit line 140 close to the second semiconductor structure 200.

For example, in some examples, as shown in FIGS. 2, 3a, and 3b, in each memory array 105, a first end (e.g., the left end in FIG. 2) of an odd-numbered word line 130 is coupled to a corresponding first contact plug 160, and a second end (e.g., the right end in FIG. 2) of an even-numbered word line 130 is coupled to a corresponding first contact plug 160. A first end (e.g., the lower end in FIG. 2) of an odd-numbered bit line 140 is coupled to a corresponding second contact plug 170, and a second end (e.g., the upper end in FIG. 2) of an even-numbered bit line 140 is coupled to a corresponding second contact plug 170. As a result, during the manufacturing process, the process window for the first contact plug 160 and the second contact plug 170 may be increased.

For example, in some examples, the first contact plug 160, the second contact plug 170, and the common electrode contact plug 150 may be simultaneously formed, that is, the three may have substantially the same structure and material composition.

For example, in some examples, as shown in FIGS. 2, 3a, and 3b, the orthographic projection of the common electrode contact plug 150 in the first direction Z is located within a region defined by four adjacent vertex corners of the orthographic projections of four adjacent memory arrays 105 in the first direction Z. Thus, the common electrode contact plug 150 may be provided with a large cross-sectional area, which facilitates the decrease of the transmission resistance of the common electrode contact plug 150.

For example, in some examples, as shown in FIGS. 2, 3a, and 3b, the area of the orthographic projection of the common electrode contact plug 150 in the first direction Z may be greater than the area of the orthographic projection of the first contact plug 160 in the first direction Z, and may also be greater than the area of the orthographic projection of the second contact plug 170 in the first direction Z.

For example, in some examples, as shown in FIGS. 3a and 3b, the first semiconductor structure 100 may further include a first interconnection layer 180, and the first interconnection layer 180 is disposed on a side of the plurality of memory arrays 105 close to the second semiconductor structure 200 in the first direction Z; the second semiconductor structure 200 may further include a second interconnection layer 220, and the second interconnection layer 220 is disposed on a side of the peripheral circuit 205 close to the first semiconductor structure in the first direction Z; the memory 10 may further include a bonding interface 300 disposed between the first interconnection layer 180 and the second interconnection layer 220. For example, the first interconnection layer 180 is boned to the second interconnection layer 220 through the bonding interface 300, to achieve the bonding between the first semiconductor structure 100 and the second semiconductor structure 200. For example, a hybrid bonding technique may be used to achieve the bonding.

For example, in some examples, as shown in FIGS. 3a and 3b, the first interconnection layer 180 may include a plurality of layers of first interconnection lines 181, first interconnection vias 182 formed between adjacent layers of first interconnection lines 181, and a plurality of first bonding pads 183. Similarly, the second interconnection layer 220 may include a plurality of layers of second interconnection lines 221, second interconnection vias 222 formed between adjacent layers of second interconnection lines 221, and a plurality of second bonding pads 223. The plurality of first bonding pads 183 and the plurality of second bonding pads 223 are bonded to each other through the bonding interface 300. For example, each of the common electrode contact plug 150, the first contact plug 160, and the second contact plug 170 is coupled to the peripheral circuit 205 through the first interconnection line 181, the first interconnection via 182, the first bonding pad 183, the second bonding pad 223, the second interconnection via 222, and the second interconnection line 221.

For example, in some examples, as shown in FIGS. 3a and 3b, the second semiconductor structure 200 may include a semiconductor substrate 201, and the peripheral circuit 205 may include a plurality of transistors 210 disposed at least partially in the semiconductor substrate 201 for achieving structures and functions of control circuits such as a word line driver (e.g., a sub-word line driver) and a sense amplifier (SA). For example, as shown in FIGS. 3a and 3b, each of the transistors 210 may include an active region 211 in the substrate, a gate 212 disposed on the active region 211, and a gate dielectric layer 213 disposed between the active region 211 and the gate 212. The semiconductor substrate 201 may be provided with trench isolation structures 207 that define each active region 211. For example, a material of the semiconductor substrate 201 may include any suitable semiconductor material, such as silicon, germanium, gallium arsenide, or an oxide semiconductor material. For example, a material of the gate 212 may include any suitable conductive material, such as titanium nitride (TiN), tantalum nitride (TaN), tungsten, metal silicide, doped polysilicon, or any combination thereof. For example, a material of the gate dielectric layer 213 may include any suitable dielectric material, such as silicon oxide, silicon nitride, a high-K dielectric material, or any combination thereof. It should be noted that the transistor 210 in the drawings is exemplary, and the structure of the transistor 210 is not limited by the embodiments of the present disclosure. For example, the transistor 210 may be a planar transistor (as shown in the drawings), a fin transistor (FinFET), or the like.

For example, in some examples, as shown in FIGS. 3a and 3b, the second semiconductor structure may further include a plurality of third contact plugs 230 disposed between the peripheral circuit 205 and the second interconnection layer 220 for achieving coupling between the peripheral circuit 205 and the second interconnection layer 220.

For example, in some examples, as shown in FIGS. 3a and 3b, the second semiconductor structure 200 may further include a third interconnection layer 280, the third interconnection layer 280 is disposed on a side of the peripheral circuit 205 away from the first semiconductor structure 100, and the third interconnection layer 280 is configured to couple the peripheral circuit 205 with an external circuit. For example, as shown in FIGS. 3a and 3b, the peripheral circuit 205 and the second interconnection layer 220 are disposed on a first face (e.g., a front face) of the semiconductor substrate 201, and the third interconnection layer 280 is disposed on a second face (e.g., a back face) of the semiconductor substrate 201.

For example, in some examples, as shown in FIGS. 3a and 3b, the third interconnection layer 280 may include a plurality of layers of third interconnection lines 281, third interconnection vias 282 formed between adjacent layers of third interconnection lines 281, and a plurality of lead-out pads 283.

For example, in some examples, as shown in FIGS. 3a and 3b, the second semiconductor structure may further include a plurality of fourth contact plugs 250 penetrating the semiconductor substrate 201 for achieving the coupling between the second interconnection layer 220 and the third interconnection layer 280. It will be understood that an isolation layer (not shown in the figures) may be disposed between the fourth contact plugs 250 and the semiconductor substrate 201 to achieve the electrical insulation between the fourth contact plugs 250 and the semiconductor substrate 201.

For example, in some examples, as shown in FIGS. 3a and 3b, the peripheral circuit 205 is coupled to the external circuit through the third contact plugs 230, the second interconnection layer 220 (e.g., the second interconnection lines 221 therein, or the second interconnection lines 221 and the second interconnection vias 222 therein), the fourth contact plugs 250, and the third interconnection layer 280 (e.g., the third interconnection lines 281, the third interconnection vias 282, and the lead-out pads 283 therein).

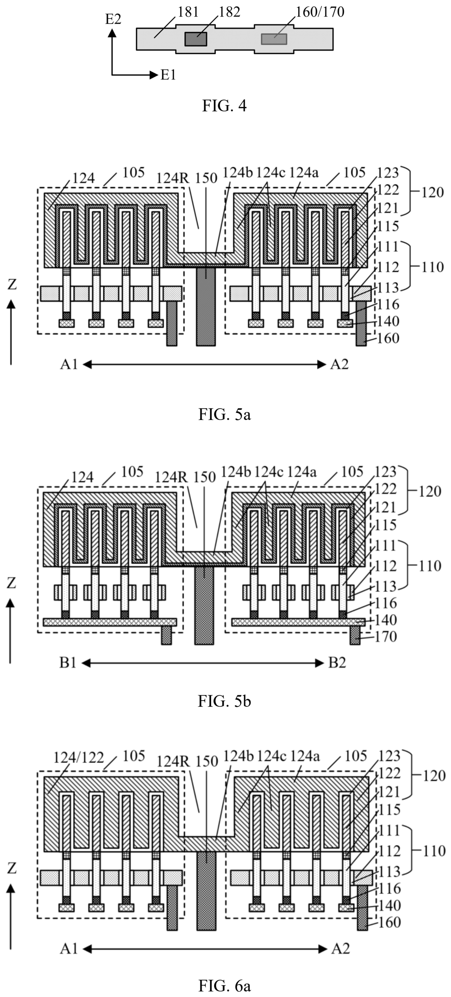

FIG. 4 is a schematic diagram of a planar structure of an interconnection line according to some embodiments of the present disclosure. For example, as shown in FIG. 4, the first interconnection line 181 is separately coupled to the first contact plug 160 (or the second contact plug 170) and the first interconnection via 182 that are located on either side of the first interconnection line, and the width of the first interconnection line 181 has a local maximum value at the coupling parts with the first contact plug 160 (or the second contact plug 170) and the first interconnection via 182, thereby facilitating the increase of the contact area and the decrease of the contact resistance. As shown in FIG. 4, the first interconnection line 181 extends in a third direction E1, and the width of the first interconnection line 181 refers to the size of the first interconnection line 181 in a fourth direction E2 perpendicular to the third direction E1. The local maximum value refers to the width of the first interconnection line 181 at a certain section being greater than its width at other sections nearby (may not necessarily be all other sections, for example, may be sections on either side of the certain section). For example, the third direction E1 and the fourth direction E2 are both parallel to the plane defined by the second direction X and the third direction Y, and the third direction E1 may be parallel to or intersect with the second direction X or the third direction Y. It should be noted that although FIG. 4 uses the first interconnection line 181, the first contact plug 160 (or the second contact plug 170), and the first interconnection via 182 as an example for illustration, the other interconnection lines and contact plugs/interconnection vias on both sides thereof may also be disposed with reference to FIG. 4.

In the present disclosure, an interconnection layer (e.g., the first interconnection layer 180, the second interconnection layer 220, or the third interconnection layer 280) may include one or more interlayer dielectric layers in which the interconnection line (e.g., the first interconnection line 181, the second interconnection line 221, or the third interconnection line 281), the interconnection via (e.g., the first interconnection via 182, the second interconnection via 222, or the third interconnection via 282), the pad (e.g., the first bonding pad 183, the second bonding pad 223, or the lead-out pad 283), and the like may all be formed. For example, materials of the interconnection line and the interconnection via may include any suitable conductive material, such as titanium nitride (TiN), tantalum nitride (TaN), tungsten, aluminum, cobalt, copper, metal silicide, doped polysilicon, or any combination thereof. For example, a material of the pad may include any suitable conductive material, including but not limited to copper. A material of the interlayer dielectric layer may include, but is not limited to, silicon oxide, silicon nitride, silicon oxynitride, a low-K dielectric material, or any combination thereof.

It should be noted that the structure of the capacitor 120 in the drawings of the present disclosure is exemplary, and the embodiments of the present disclosure do not limit the structure of the capacitor 120, as long as the arrangement of the first electrode 121, the second electrode 122, and the capacitor dielectric layer 123 can form the capacitor 120. For example, the first electrode 121 may be columnar (as shown in the drawings), plate-shaped, U-shaped, or in any other suitable shape; the second electrode 122 conformally covers the sidewalls and/or the top face of the first electrode 121, and the capacitor dielectric layer 123 is located between the first electrode 121 and the second electrode 122. For example, in some examples, in the first semiconductor structure 100, one or more support layers for supporting the first electrode may be disposed, and the support layers may be grid-like. The capacitor dielectric layer 123 and the second electrode 122 may partially cover the support layers.

FIG. 5a is a schematic diagram of a partial cross-sectional structure of a memory taken along line A1A2 in FIG. 2 according to some other embodiments of the present disclosure; FIG. 5b is a schematic diagram of a partial cross-sectional structure of a memory taken along line B1B2 in FIG. 2 according to some other embodiments of the present disclosure. It should be noted that compared with FIGS. 3a and 3b, only part of the structure of the memory is shown in FIGS. 5a and 5b for simplicity. The structures not shown in FIGS. 5a and 5b can be referenced from the corresponding structures in FIG. 3a and 3b.

The main difference between the memory in the embodiments shown in FIGS. 5a and 5b and the memory in the embodiments shown in FIGS. 3a and 3b lies in that: For the memory in the embodiments shown in FIGS. 5a and 5b, the second electrode 122 is integrally formed in each memory array 105, and the capacitor dielectric layer 123 is integrally formed in each memory array 105. Further, the second electrode 122 is integrally formed in a plurality of memory arrays 105, but the capacitor dielectric layers 123 of different memory arrays of the plurality of memory arrays 105 are separated from each other. In this case, as shown in FIGS. 5a and 5b, one end of the common electrode contact plug 150 may make a direct contact connection with the shared second electrode 122 without penetrating the capacitor dielectric layer 123. It will be understood that on the basis of the embodiments shown in FIGS. 5a and 5b, one end of the common electrode contact plug 150 may penetrate the shared second electrode 122 to make a direct contact connection with the common electrode 124. It will also be understood that in some examples, the second electrodes 122 of different memory arrays of the plurality of memory arrays 105 may be separated from each other, such that one end of the common electrode contact plug 150 may make a direct contact connection with the common electrode 124.

The features of the remaining structures of the memory in the embodiments shown in FIGS. 5a and 5b can be referenced from the related descriptions of FIGS. 3a and 3b, and details are not repeated herein.

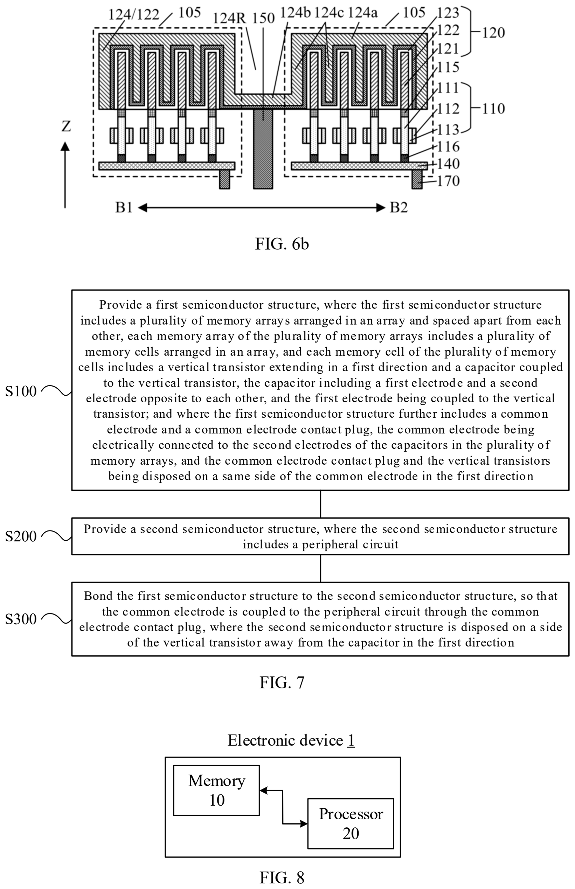

FIG. 6a is a schematic diagram of a partial cross-sectional structure of a memory taken along line A1A2 in FIG. 2 according to yet some other embodiments of the present disclosure; FIG. 6b is a schematic diagram of a partial cross-sectional structure of a memory taken along line B1B2 in FIG. 2 according to yet some other embodiments of the present disclosure. It should be noted that similar to FIGS. 5a and 5b, only part of the structure of the memory is shown in FIGS. 6a and 6b for simplicity. The structures not shown in FIGS. 6a and 6b can be referenced from the corresponding structures in FIGS. 3a and 3b.

The main difference between the memory in the embodiments shown in FIGS. 6a and 6b and the memory in the embodiments shown in FIGS. 5a and 5b lies in that: In the memory in the embodiments shown in FIGS. 6a and 6b, the second electrode 122 and the common electrode 124 are integrally formed, such that process steps can be simplified. In other words, the second electrode 122 and the common electrode 124 are formed as an integral structure, and both are not strictly distinguished or are considered as a part of the integral structure. For example, in some examples, the second electrode 122 and the common electrode 124 in the embodiments shown in FIGS. 3a and 3b may also be considered as an integral structure, that is, the integral structure may be a multi-layer structure and does not have to be a single-layer structure.

The features of the remaining structures of the memory in the embodiments shown in FIGS. 6a and 6b can be referenced from the related descriptions of FIGS. 3a and 3b, and details are not repeated herein.

For example, in some embodiments, the memory 10 may include a plurality of memory banks. Each memory bank includes a plurality of memory arrays (i.e., a plurality of memory arrays 105), and the plurality of memory arrays in each memory bank share the same common electrode (i.e., the common electrode 124), that is, each memory bank corresponds to one common electrode; common electrodes corresponding to different memory banks are separated from each other. For example, passive devices may be disposed between adjacent memory banks. For example, the passive devices include, but are not limited to, decoupling capacitors and the like.

For example, the memory 10 may be a dynamic random access memory (DRAM) or a ferroelectric random access memory (Fe-RAM), but is not limited thereto.

It should be noted that for clarity and simplicity, most of the insulating layer and/or the dielectric layer, etc., in the first semiconductor structure and the second semiconductor structure are omitted in the drawings. For example, the filling layer and the support layer described above are omitted.

In at least some embodiments of the present disclosure, a method for manufacturing a memory is further provided. The manufacturing method is applicable to manufacture the memory in the above embodiments. FIG. 7 is a flow chart of a method for manufacturing a memory according to some embodiments of the present disclosure. For example, as shown in FIG. 7, the manufacturing method may include the following steps S100 to S300.

In S100, a first semiconductor structure is provided, where the first semiconductor structure includes a plurality of memory arrays arranged in an array and spaced apart from each other, each memory array of the plurality of memory arrays includes a plurality of memory cells arranged in an array, each memory cell of the plurality of memory cells includes a vertical transistor extending in a first direction and a capacitor coupled to the vertical transistor, the capacitor includes a first electrode and a second electrode opposite to each other, and the first electrode is coupled to the vertical transistor; the first semiconductor structure further includes a common electrode and a common electrode contact plug, the common electrode being electrically connected to the second electrodes of the capacitors in the plurality of memory arrays, and the common electrode contact plug and the vertical transistors being disposed on the same side of the common electrode in the first direction.

For example, in some examples, taking the first semiconductor structure 100 shown in FIGS. 2, 3a, and 3b as an example, providing the first semiconductor structure may include: forming vertical transistors 110, word lines 130, contact pads 115, capacitors 120, and a common electrode 124 on a first face (e.g., a front face) of a substrate; thinning or removing the substrate from a second face (e.g., a back face) of the substrate, and forming bit lines 140, a common electrode contact plug 150, first contact plugs 160, second contact plugs 170, and a first interconnection layer 180.

In S200, a second semiconductor structure is provided, where the second semiconductor structure includes a peripheral circuit.

For example, in some examples, taking the second semiconductor structure 200 shown in FIGS. 2, 3a, and 3b as an example, providing the second semiconductor structure may include: forming a peripheral circuit 205 (as shown by the transistor 210 in the drawings), third contact plugs 230, and a second interconnection layer 220 on a first face (e.g., a front face) of a semiconductor substrate 201; thinning the semiconductor substrate 201 from a second face (e.g., a back face) of the semiconductor substrate 201, and forming fourth contact plugs 250 and a third interconnection layer 280.

In S300, the first semiconductor structure is bonded to the second semiconductor structure, so that the common electrode is coupled to the peripheral circuit through the common electrode contact plug, where the second semiconductor structure is disposed on a side of the vertical transistor away from the capacitor in the first direction.

For example, a hybrid bonding technique may be used to bond the first semiconductor structure to the second semiconductor structure.

For example, in some examples, taking the memory 10 shown in FIGS. 2, 3a, and 3b as an example, bonding the first semiconductor structure 100 to the second semiconductor structure 200 may include: bonding the first interconnection layer 180 to the second interconnection layer 220, to achieve the bonding between the first semiconductor structure 100 and the second semiconductor structure 200, where a bonding interface 300 is located between the first interconnection layer 180 and the second interconnection layer 220.

It should be noted that one or more steps of the above manufacturing method may include a plurality of sub-steps, which may be performed sequentially or in parallel according to actual needs. In addition, sub-steps in different steps may be performed sequentially, in parallel, or alternatively according to actual needs.

For example, in some embodiments, the first semiconductor structure may be first provided; then an initial second semiconductor structure is provided, that is, the peripheral circuit 205 (as shown by the transistor 210 in the drawings), the third contact plugs 230, and the second interconnection layer 220 are formed on the first face (e.g., the front face) of a semiconductor substrate 201; subsequently, the first semiconductor structure is bonded to the initial second semiconductor structure; finally, the semiconductor substrate 201 of the initial second semiconductor structure is thinned from the second face (e.g., the back face) of the semiconductor substrate 201, and the fourth contact plugs 250 and the third interconnection layer 280 are formed.

More details and technical effects of the manufacturing method provided according to the embodiments of the present disclosure can be referenced from the related descriptions in the above embodiments of the memory, and details are not repeated herein.

In at least some embodiments of the present disclosure, an electronic device is further provided. FIG. 8 is a schematic block diagram of a structure of an electronic device according to some embodiments of the present disclosure. As shown in FIG. 8, the electronic device 1 includes a processor 20 and the memory 10 in the above embodiments. The memory 10 is coupled to the processor 20.

For example, the processor 20 may include, but is not limited to, a Central Processing Unit (CPU), a Graphics Processing Unit (GPU), and the like. The memory 10 may be configured to store data to be processed by the processor 20 and/or data that have been processed by the processor.

For example, the electronic device 1 includes, but is not limited to, a cell phone, a tablet, a smart bracelet, a wearable electronic device, a virtual reality device, an augmented reality device, an in-vehicle device, a server, a workstation, and the like.

The above description is only the specific embodiments of the present disclosure, but the protection scope of the present disclosure is not limited thereto; changes or substitutions that any of those skilled in the art can easily think of within the technical scope disclosed by the present disclosure shall all fall within the protection scope of the present disclosure. Therefore, the protection scope of the present disclosure shall be defined by the protection scope of the claims.

## Claims

1. A memory (10), comprising:
a first semiconductor structure (100), comprising a plurality of memory arrays (105) arranged in an array and spaced apart from each other, wherein each memory array of the plurality of memory arrays comprises a plurality of memory cells arranged in an array, and each memory cell of the plurality of memory cells comprises a vertical transistor (110) extending in a first direction (Z) and a capacitor (120) coupled to the vertical transistor, the capacitor comprising a first electrode (121) and a second electrode (122) opposite to each other, and the first electrode being coupled to the vertical transistor; and
a second semiconductor structure (200), comprising a peripheral circuit (205) and being bonded to the first semiconductor structure, wherein the second semiconductor structure is disposed on a side of the vertical transistor away from the capacitor in the first direction,
wherein the first semiconductor structure further comprises a common electrode (124) and a common electrode contact plug (150), the common electrode being electrically connected to the second electrodes of the capacitors in the plurality of memory arrays, and the common electrode contact plug and the vertical transistors being disposed on a same side of the common electrode in the first direction, the common electrode being coupled to the peripheral circuit through the common electrode contact plug.

2. The memory according to claim 1, wherein the common electrode comprises a plurality of first plate-shaped portions (124a) in one-to-one correspondence with the plurality of memory arrays and a second plate-shaped portion (124b) connecting the plurality of first plate-shaped portions, the second plate-shaped portion being disposed between adjacent memory arrays and closer to the second semiconductor structure than the plurality of first plate-shaped portions.

3. The memory according to claim 2, wherein an orthographic projection of the common electrode contact plug along the first direction is located within an orthographic projection of the second plate-shaped portion along the first direction.

4. The memory according to claim 2 or 3, wherein the common electrode further comprises extension portions (124c) extending in the first direction, each of the extension portions being disposed on a sidewall of the first electrode and connected to a corresponding first plate-shaped portion, and the plurality of first plate-shaped portions being connected to the second plate-shaped portion through the extension portions.

5. The memory according to claim 2 or 3, wherein the plurality of first plate-shaped portions and the second plate-shaped portion are integrally formed.

6. The memory according to any one of claims 1 to 5, wherein an orthographic projection of the common electrode contact plug along the first direction is located within a region defined by four adjacent vertex corners of orthographic projections of four adjacent memory arrays along the first direction.

7. The memory according to any one of claims 1 to 6, wherein the capacitor further comprises a capacitor dielectric layer (123) disposed between the first electrode and the second electrode, the capacitor dielectric layer being integrally formed in the plurality of memory arrays, and the common electrode contact plug penetrating the capacitor dielectric layer and being coupled to the common electrode.

8. The memory according to any one of claims 1 to 6, wherein the capacitor further comprises a capacitor dielectric layer disposed between the first electrode and the second electrode, the capacitor dielectric layer being integrally formed in each of the plurality of memory arrays, and the capacitor dielectric layers of different memory arrays of the plurality of memory arrays being separated from each other.

9. The memory according to any one of claims 1 to 8, wherein the second electrode is integrally formed in each of the plurality of memory arrays, and the second electrodes of different memory arrays of the plurality of memory arrays are integrally formed or separated from each other.

10. The memory according to any one of claims 1 to 8, wherein the second electrode in the plurality of memory arrays and the common electrode are integrally formed.

11. The memory according to any one of claims 1 to 10, wherein each of the plurality of memory arrays further comprises a plurality of word lines (130) extending in a second direction (X) and a plurality of bit lines (140) extending in a third direction (Y), wherein
in each of the plurality of memory arrays, each word line of the plurality of word lines is coupled to a row of vertical transistors arranged in the second direction, and each bit line of the plurality of bit lines is coupled to a column of vertical transistors arranged in the third direction; and
the second direction is perpendicular to the first direction, the third direction is perpendicular to the first direction, and the third direction intersects with the second direction.

12. The memory according to claim 11, wherein the word lines in adjacent memory arrays are spaced apart from each other, and the bit lines in adjacent memory arrays are spaced apart from each other.

13. The memory according to claim 11 or 12, wherein the first semiconductor structure further comprises:
a plurality of first contact plugs (160) in one-to-one correspondence with and coupled to the plurality of word lines in each of the plurality of memory arrays, each first contact plug of the plurality of first contact plugs being disposed on a side of a corresponding word line close to the second semiconductor structure; and
a plurality of second contact plugs (170) in one-to-one correspondence with and coupled to the plurality of bit lines in each of the plurality of memory arrays, each second contact plug of the plurality of second contact plugs being disposed on a side of a corresponding bit line close to the second semiconductor structure.

14. The memory according to any one of claims 1 to 13, wherein the first semiconductor structure further comprises a first interconnection layer (180), the first interconnection layer being disposed on a side of the plurality of memory arrays close to the second semiconductor structure in the first direction;
the second semiconductor structure further comprises a second interconnection layer (220), the second interconnection layer being disposed on a side of the peripheral circuit close to the first semiconductor structure in the first direction; and
the memory further comprises a bonding interface (300) disposed between the first interconnection layer and the second interconnection layer.

15. The memory according to any one of claims 1 to 14, wherein the second semiconductor structure further comprises a third interconnection layer (280), the third interconnection layer being disposed on a side of the peripheral circuit away from the first semiconductor structure, and the third interconnection layer being configured to couple the peripheral circuit with an external circuit.

16. An electronic device (1), comprising:
a processor (20); and
the memory (10) according to any one of claims 1 to 13, the memory being coupled to the processor.

17. A method for manufacturing a memory, comprising:
providing a first semiconductor structure, wherein the first semiconductor structure comprises a plurality of memory arrays arranged in an array and spaced apart from each other, each memory array of the plurality of memory arrays comprises a plurality of memory cells arranged in an array, and each memory cell of the plurality of memory cells comprises a vertical transistor extending in a first direction and a capacitor coupled to the vertical transistor, the capacitor comprising a first electrode and a second electrode opposite to each other, and the first electrode being coupled to the vertical transistor; and wherein the first semiconductor structure further comprises a common electrode and a common electrode contact plug, the common electrode being electrically connected to the second electrodes of the capacitors in the plurality of memory arrays, and the common electrode contact plug and the vertical transistors being disposed on a same side of the common electrode in the first direction;
providing a second semiconductor structure, wherein the second semiconductor structure comprises a peripheral circuit; and
bonding the first semiconductor structure to the second semiconductor structure, so that the common electrode is coupled to the peripheral circuit through the common electrode contact plug, wherein the second semiconductor structure is disposed on a side of the vertical transistor away from the capacitor in the first direction.
